(19) Europäisches Patentamt

European Patent Office

Office européen des brevets

(11) **EP 1 519 423 A1**

(12) **EUROPEAN PATENT APPLICATION**
published in accordance with Art. 158(3) EPC

(43) Date of publication:
**30.03.2005 Bulletin 2005/13**

(51) Int Cl.⁷: **H01L 33/00**

(21) Application number: **03728106.0**

(86) International application number:
**PCT/JP2003/006234**

(22) Date of filing: **19.05.2003**

(87) International publication number:
**WO 2004/004018 (08.01.2004 Gazette 2004/02)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **28.06.2002 JP 2002190236**

(71) Applicant: **SUMITOMO ELECTRIC INDUSTRIES, Ltd**
**Osaka-shi, Osaka 541-0041 (JP)**

(72) Inventors:
 • **NAKAMURA, Takao,**
 **Osaka Works Sumitomo Elec. Ind.**
 **Osaka-shi, Osaka 554-0024 (JP)**

 • **FUJIWARA, Shinsuke,**
 **Osaka Works Sumitomo Elec. In.**
 **Osaka-shi, Osaka 554-0024 (JP)**
 • **MATSUBARA, Hideki,**
 **Osaka Works Sumitomo Elec. Ind.**
 **Osaka-shi, Osaka 554-0024 (JP)**

(74) Representative: **Grünecker, Kinkeldey, Stockmair & Schwanhäusser Anwaltssozietät**
**Maximilianstrasse 58**
**80538 München (DE)**

(54) **SEMICONDUCTOR LIGHT-EMITTING DEVICE**

(57)    A ZnSe light-emitting device emitting light from an output face comprises an n-type ZnSe substrate including self-active luminescence centers (SA), an active layer formed on the n-type ZnSe substrate, and an Al layer provided the opposite side to the output face and serving to reflect light toward the output face. The emitted light is effectively used, the luminance is high, and the chromaticity of the white light-emitting device can be easily adjusted.

FIG. 10

EP 1 519 423 A1

**Description**

Technical Field

The present invention relates to a semiconductor light emitting device, and more particularly, to a ZnSe light-emitting device.

Background Art

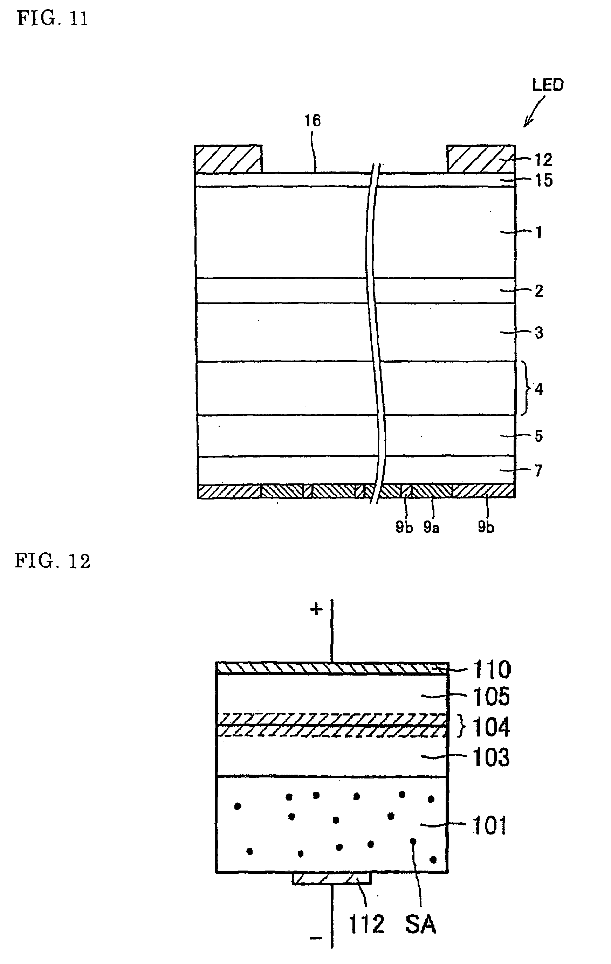

In a ZnSe white light emitting device, blue light is generated at an active layer which includes a pn-junction and which is formed on an n-type ZnSe substrate, and self-activated radiative recombination centers (SA centers) in the ZnSe substrate receive the blue light, whereby the SA centers, being excited, emit yellow light. Figure 12 schematically shows the ZnSe white-light emitting device, in which n-type ZnSe epitaxial layer 103 is formed on an n-type ZnSe substrate 101 having SA centers, and an active layer 104 which is a light-emitting layer including at least one pn-junction is formed on the epitaxial layer 103. A p-type ZnSe epitaxial layer 105 is formed on the active layer 104. In order to cause the active layer 104 to generate light, a voltage is applied between an n-type electrode 112 provided on the rear surface of the n-type ZnSe substrate 101 and a p-type electrode 110 provided on the p-type ZnSe epitaxial layer 105. A predetermined voltage is applied to the p-type electrode 110 and a lower voltage than that is applied to the n-type electrode 112 so that a forward voltage is applied to the pn-junction. A carrier is injected to the pn-junction by the application of voltage and light is generated at the active layer 104. In the case of a ZnSe compound semiconductor, the light emitted from the active layer is blue according to the wavelength corresponding to the ZnSe layer within the active layer. This blue light has a narrow bandwidth.

The blue light is not only emitted outside from the output surface via the p-type ZnSe epitaxial layer on the upper side but also allowed to reach the n-type ZnSe substrate 101 on the lower side. The n-type ZnSe substrate is doped beforehand with at least one kind of doping selected from the group consisting of iodine, aluminum, chlorine, bromine, gallium, and indium so that it has n-type conductivity. By this doping, SA radiative recombination centers are formed in the ZnSe substrate.

Light having a long wavelength in the range of 550 nm - 650 nm is emitted from the SA radiative recombination centers as a result of the irradiation of light having a short wavelength in the range of 510nm or less including the above-mentioned blue light. This light in the long wavelength range is visible light of yellow or orange color.

Of the blue or blue-green light from the active layer in the figure, the light which propagates toward the ZnSe substrate is absorbed in the ZnSe substrate 101, thereby causing the excitation of light, which is yellow, orange, or red. White light can be obtained by combining the blue or blue-green light and the excited light of yellow, orange, or red color.

Disclosure of the Invention

As described above, in order to cause a ZnSe semiconductor light-emitting device to emit light, a voltage must be applied between a p-type electrode disposed on a p-type semiconductor layer and a n-type electrode formed on the rear surface of an n-type ZnSe substrate.

In the past, In by the fusion bond method and Au/Ti by a regrowth or vacuum evaporation method were used for the n-type electrode formed on the rear surface of the n-type ZnSe substrate. These metals, the reflectivity of which is low with respect to blue or blue-green light from the active layer and light in a long wavelength range generated in the n-type ZnSe substrate, absorb substantial amount of such light.

As mentioned above, the ZnSe light emitting device uses light of a long-wavelength range generated in the ZnSe substrate in addition to light of a short-wavelength range generated in the active layer. Therefore, it is important to effectively extract, as much as possible, light generated in the ZnSe substrate so that the improvement of output and control of chromaticity can be achieved.

A main object of the present invention is to provide a semiconductor light emitting device capable of high intensity by effectively utilizing light generated in a semiconductor element. A secondary object is to adjust the chromaticity of light emitting semiconductor device for emitting white light and to restrain the variations in the output and chromaticity thereof.

The semiconductor light emitting device of the present invention is a semiconductor light emitting device which emits light outside from the output surface. The semiconductor light emitting device has a first conductivity-type semiconductor substrate including self-activated radiative recombination centers, an active layer formed above the first conductivity-type semiconductor substrate, and an Al layer which is provided on the surface opposite the output surface and which reflects light toward the output surface side.

It is possible to improve the output, that is, the brightness, by arranging the Al layer on the mounting substrate side, which is opposite the output surface, as described above so that blue light generated at the active layer and SA light from the inside of the semiconductor substrate are reflected at the Al layer so as to be directed toward the output surface.

Light generated at the SA radiative recombination centers also is reflected at the Al layer so as to be utilized, and in addition, the light of a short wavelength range which has been reflected excites the SA radiative recombination centers once again when it passes through the semiconductor substrate, whereby the intensity of light of a long wavelength range increases accordingly, and light from the active layer, which light has contributed for such excitation, is absorbed and the intensity thereof decreases. Therefore, the component of light from the SA radiative recombination centers can be enhanced relative to the component of light from the active layer in white light.

The above-mentioned light emitting device may be either of epi-side up assembly or epi-side down assembly when it is mounted. The term "epi-side up assembly", etc. is the term which shows the direction toward which the light emitting device faces when mounted, since a first and second conductivity-type semiconductor layers are formed on the substrate by epitaxial growth. The term "epi-up" (i.e., substrate-down) means that a semiconductor substrate is fixed on a mounting substrate and that the epitaxial layer constitutes an output surface, and "epi-down" (i.e., substrate up) means that the epitaxial layer side is fixed on a mounting substrate and that the semiconductor substrate constitutes an output surface. The above-mentioned Al layer can be used for either a semiconductor light emitting device for epi-up mounting or that for epi-down mounting. That is, the above-mentioned output surface may be located on the side of the second-conductivity-type semiconductor layer formed on the active layer, and the Al layer constitutes an electrode that is electrically connected with the first conductivity-type semiconductor substrate.

By employing such a structure as described above, high intensity of light can be achieved by the reflection at the Al layer in the epi-up mounting. That is, the SA radiative recombination centers in the semiconductor substrate are excited twice: when light from the active layer is directed toward the Al layer and when the light is reflected at the Al layer toward the output surface. Therefore, the intensity of SA light is enhanced, and the intensity of light from the active layer can also be increased.

The light emitting device may have a structure in which a first conductivity-type semiconductor layer containing first conductivity-type impurities at a higher concentration than a first conductivity-type semiconductor substrate is provided on the surface (rear surface) of the first conductivity-type semiconductor substrate, and the Al layer is provided in contact with the first conductivity-type semiconductor layer containing high' concentration of impurities. This structure enables a back side electrode to be ohmic contact easily in the case of epi-up mounting.

The above-mentioned output surface may be located on the first conductivity-type semiconductor substrate side and on the side of the second conductivity-type semiconductor layer where the Al layer is formed on the active layer. With this structure, also in epi-down mounting, the effective utilization of light generated in the semiconductor light emitting device can be achieved such that the brightness is enhanced.

Also, it is possible to provide an Au layer and/or two layers of Ti (lower layer) / Au (upper layer) on the above-mentioned Al layer. The unstable Al layer can be stabilized by the protection of the Au layer or the Ti/Au layers.

The structure of the light emitting device may be such that the above-mentioned first conductivity-type semiconductor substrate is an n -type ZnSe substrate including self activated radiative recombination centers, and an active layer including a pn-junction is provided above the n-type ZnSe substrate. When the n-type ZnSe that is comparatively easy to manufacture as a semiconductor substrate is used as described above and epi-up mounting is implemented, for example, light generated in the active layer reaches the Al layer. The amount of light that reaches the surface (rear surface) of the ZnSe substrate from the active layer depends on the absorption coefficient of the substrate. The absorption coefficient of the ZnSe substrate made by the Physical Vapor Transport (PVT) method is not so large and a substantial amount of light reaches the surface (rear surface) of the ZnSe substrate from the active layer. The light that has reached the rear surface is reflected at the Al layer so as to be returned upward. In contrast, in the case where an In-electrode or Ti-electrode is used as a conventional back side electrode, light has almost been absorbed at the back side electrode. By arranging an Al layer as mentioned above, the light is reflected toward the light-emitting portion such that it passes ZnSe substrate again. When the light from the active layer passes ZnSe substrate again upward, light of a long wavelength range is generated again from the radiative recombination centers in the ZnSe substrate. Therefore, not only is the brightness improved as a whole, but also the ratio of the light from the SA radiative recombination centers can be relatively increased. Accordingly, white light of a cold color can be improved to be closer to the complete white light, and moreover white light of a warm color can be obtained, for example.

Brief Description of the Drawing

Figure 1 illustrates the principle of method for measuring the reflectivity in an embodiment 1 of the present invention: Fig. 1 (a) shows the measurement of the reflectivity r1 that includes a reflection from the surface which is in touch with air; and Fig. 1 (b) shows the measurement of reflectivity r0 and transmitted light T0 in order to obtain the necessary reflectivity R1, complementing the measurement of Fig. 1 (a).

Figure 2 shows the results of measurement of transmitted light T0 in the case of a Ti/Au electrode.

Figure 3 shows the results of measurement of reflectivity r0 in the case of the Ti/Au electrode.

Figure 4 shows the absorption coefficient "a" calculated from the results of measurement of T0 and r0.

Figure 5 is shows the reflectivity R0 at the air / ZnSe interface according to the calculation from the results of measurement of T0 and r0.

Figure 6 shows the results of measurement of the reflectivity r1 in the case where a Ti/Au film is formed by vacuum evaporation on one face of the samples.

Figure 7 shows the results of calculation of reflectivity R1 at the Ti/ZnSe interface.

Figure 8 shows the results of measurement of the reflectivity r1 in the cases where an Al layer, In layer and Ti layer are provided respectively on the rear surface of the ZnSe substrate.

Figure 9 shows the results of calculation of the reflection R1 at the respective interfaces between the ZnSe layer and the Al-layer, In-layer and Ti-layer, respectively.

Figure 10 illustrates a sectional view of the ZnSe light emitting device in an embodiment 2 of the present invention.

Figure 11 illustrates a sectional view of the ZnSe light emitting device in an embodiment 3 of the present invention.

Figure 12 shows a conventional ZnSe light emitting device.

Best Mode for Carrying out the Invention

The embodiments of the present invention are described hereinafter in reference to the accompanying drawings.

(Embodiment 1)

In a ZnSe white LED of the semiconductor light emitting device, a part of the blue light from the epitaxial active layer formed on the n-type ZnSe substrate performs excitation in the SA centers in the ZnSe substrate when passing therethrough. At that time, a part of the blue light is absorbed because of the excitation. Whitening of light is achieved by utilizing the SA light generated in the process of the relaxation of the excitation in the SA centers. In the white LED a metallic n-type electrode is formed on the rear surface of the ZnSe substrate. When the absorption of the blue light in the ZnSe substrate is insufficient, a part of the blue light reaches the back side electrode of the ZnSe substrate. On the other hand, a substantial amount of the SA light reaches a back side electrode because the SA light, which is isotropic, is radiated in an equal amount toward the output surface side and the mounting surface side, respectively.

If the reflectivity in a back side electrode of the ZnSe substrate is 100 %, there is no problem even if the light reaches the back side electrode. In practice, however, it is impossible to have 100 % reflectivity and some amount of absorption cannot be avoided. Therefore, the reflectivity at the back side electrode interface in the ZnSe is an important factor for determining the emitting property of the white light LED. However, there has been no available knowledge about the reflectivity actually measured so far. Thus, the measurement of reflectivity at the back side electrode interface of the ZnSe substrate was performed. As for the back side electrodes, a Ti layer, In layer, and Al layer were used, and the following results were obtained.

(a1) Principle of reflectivity measurement

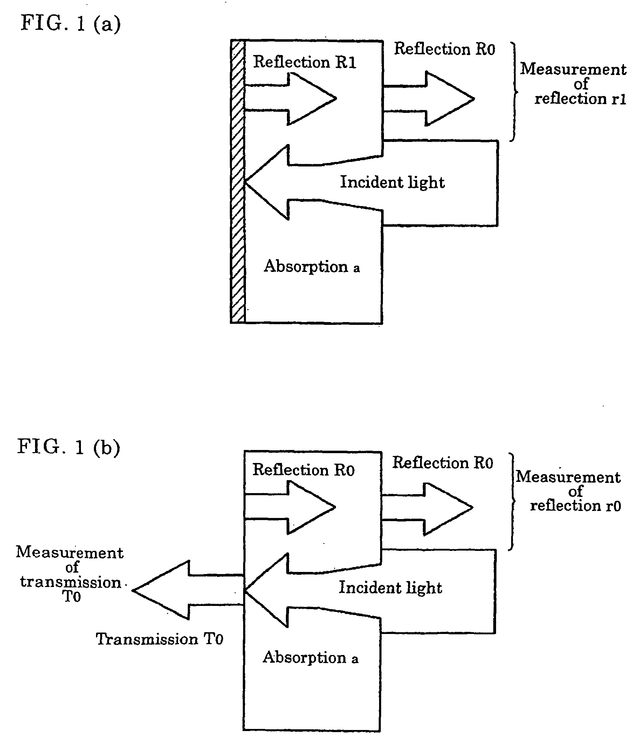

When the reflectivity is measured in the arrangement shown in Fig. 1 (a), measured reflectivity (r1) is a value which includes a reflectivity (R0) at an air / ZnSe interface, absorption coefficient (a) in the ZnSe, and reflectivity (R1) at the ZnSe / back side electrode interface. Therefore, R1 cannot be determined by simply measuring r1 only. In addition to the measurement of r1, the reflectivity (r0) and transmissivity (T0) are measured in the arrangement of Fig. 1 (b), that is, in the state where there is no back side electrode, and R0, R1, r1 and a can be obtained from the results of these three measurements.

There is the following relationship between r1, r0, and T0, which are measured values, and R0, R1 and a, when the multiple reflections also are taken into consideration.

$$r0 = R0 + [\{A^2 \cdot R0 \cdot (1-R0)^2\} / \{1-(A \cdot R0)^2\}]$$

$$T0 = \{A \cdot (1-R0)^2\} / \{1-(A \cdot R0)^2\}$$

$$r1 = R0 + [\{A^2 \cdot R1 \cdot (1-R0)^2\} / \{1-A^2 \cdot R0 \cdot R1\}]$$

$$A = \exp(-a \cdot d)$$

where, d is the thickness of the ZnSe substrate. Using these relational expressions, R0, R1, and a can be calculated from measured values of r1, r0, and T0.

(a2) Measurement in the case of a Ti/Au electrode

The following three samples are used for the measurement:

(s1) An as-grown PVT substrate (Physical Vapor Transport method)
(s2) An Al-doped PVT substrate
(s3) A CVT substrate (Chemical Vapor Transport method)

Each wafer, after being cleaved to 10 mm $\times$ 10mm, was mirror-polished on both surfaces so as to have a thickness of 200 $\mu$m. As for sample (s2) the Al-doped PVT, each surface was polished such that there remained a region where Al existed.

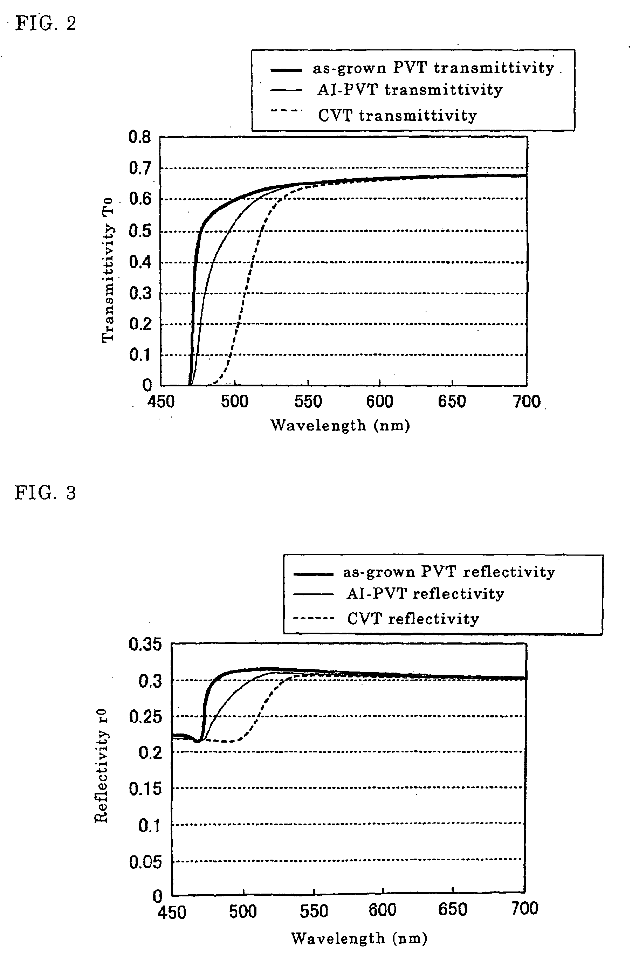

The transmissivity T0 and reflectivity r0 were measured with respect to the above three samples prior to the deposition of an electrode. The results of measurements are shown in Figs. 2 and 3.

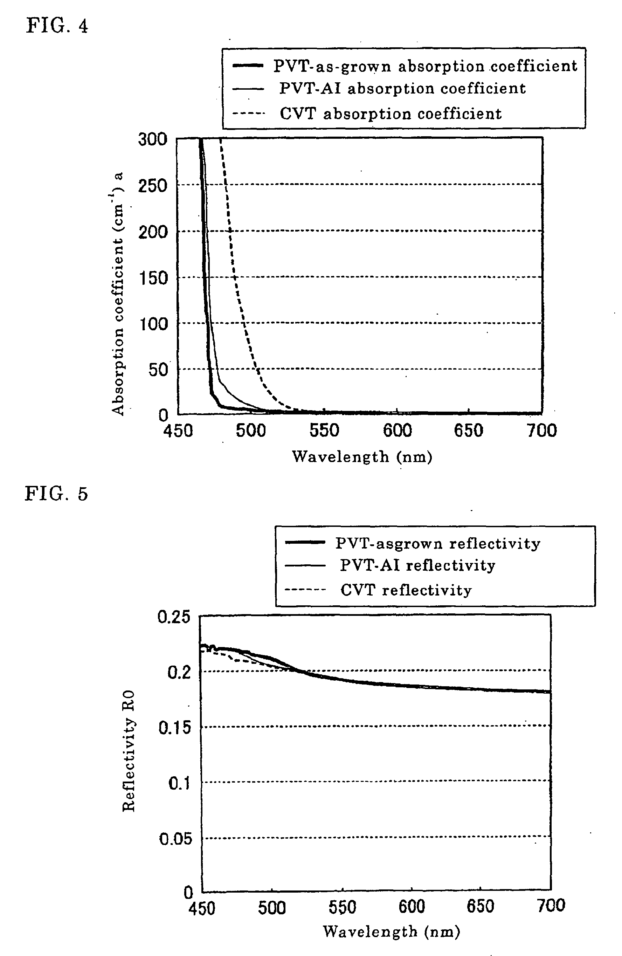

The differences in the transmissivity are due to the difference of existence or non-existence of doping and the difference in the kind of dopants. The absorption edge shifts to the longer wavelength side when there is a doping. Such tendency is more conspicuous in the case of iodine than Al. The reflectivity does not change so much in the long wavelength side, and differs significantly at the neighborhood of the absorption edge. However, this is not sufficient for determining whether it is due to the influence of absorption or the difference in the reflectivity R0 at the interface. The results of calculation based on the results of the above-mentioned measurements in terms of reflectivity R0 at the air / ZnSe interface and absorption coefficient a are shown in Fig. 4 and Fig. 5. According to these figures, the values of R0 do not differ so significantly in each sample.

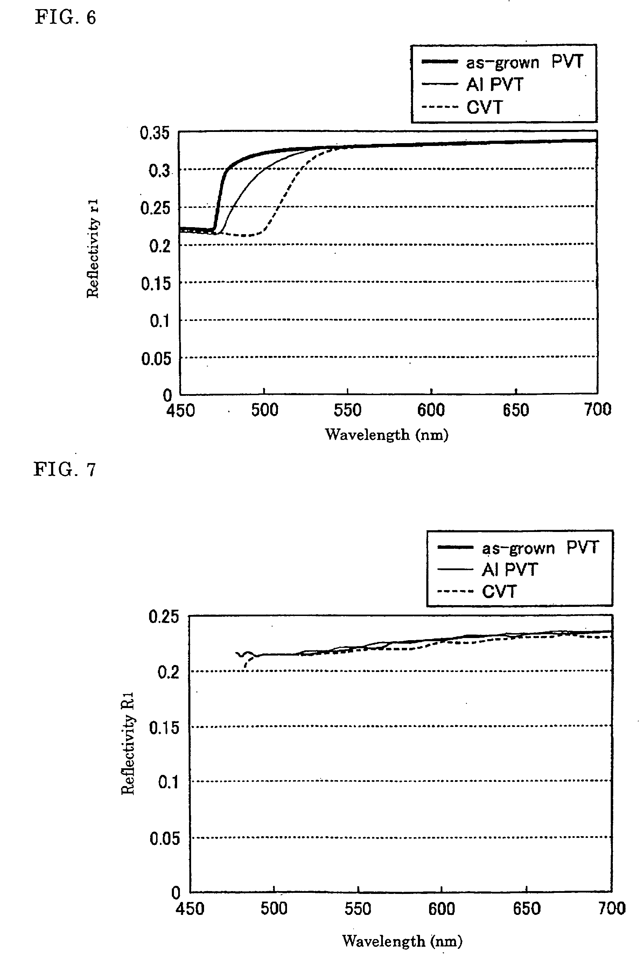

Next, a thin Ti/Au film was formed by vacuum evaporation on one surface of these samples. The film thickness of Ti was 500Å and that of Au was 1000Å. It is considered that there was no substantial influence ofAu that was formed after Ti because the Ti film was sufficiently thick and incident light would not penetrate therethrough. The results of measurements of reflectivity r1 are shown in Fig. 6.

The values of the reflectivity R1 at the Ti/ZnSe interface, which are calculated based on these measurements of reflectivity r1, are as shown in Fig. 7. As can be seen from Fig. 7, the reflectivity R1 at the Ti/ZnSe interface is not so high. Much of the incident light that has reached a back side electrode is absorbed and lost. When the CVT substrate is used, blue light does not reach the rear surface because the absorption coefficient thereof with respect to the blue light is large (refer to Fig. 4). However, the absorption loss of light is inevitable, since a part of the SA light converted from the blue light still reaches the rear surface. When a PVT substrate is used, a part of blue light reaches the rear surface and is absorbed and lost because the absorption coefficient thereof with respect to blue light is small. A part of SA light in addition to the blue light from the active layer is also lost.

(a3) Measurement in the cases of an In-electrode and Al-electrode

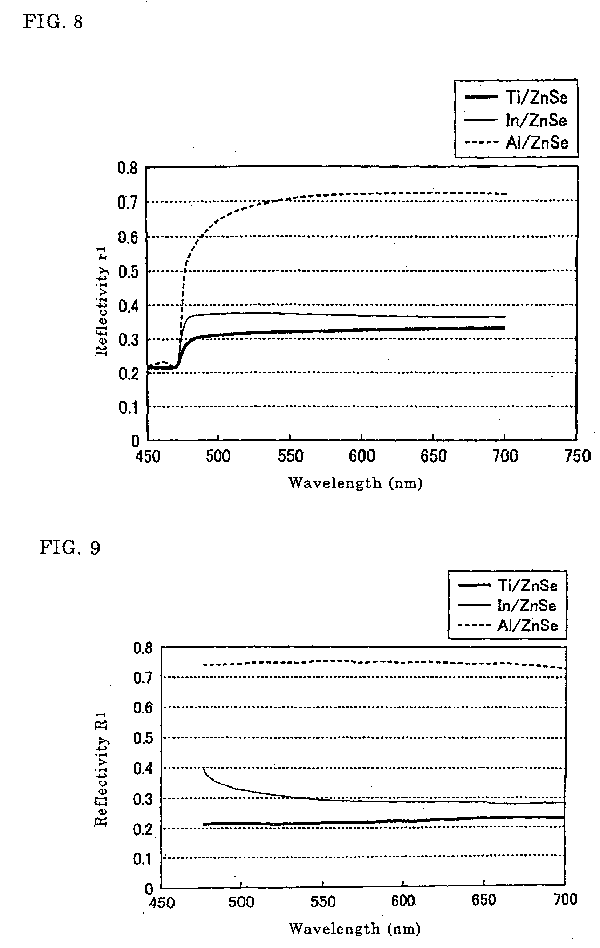

The reflectivity R1 with respect to In and Al was evaluated by depositing In or Al on one surface of an as-grown PVT substrate and by measuring the reflectivity r1. Here, without making new measurement, the values obtained by measurement in (a2) were used as the absorption coefficient "a" and reflectivity R0 of the as-grown PVT substrate. The measured reflectivity r1 and the reflectivity R1 at the In or Al / ZnSe interface that was estimated therefrom are shown in Figs. 8 and 9.

As can be understood from Figs. 8 and 9, in the case where an In electrode was used, the reflectivity is higher than in the case of the Ti electrode, but that is not a substantial improvement. In contrast, a significant improvement in the reflectivity was achieved when an Al electrode was used. Therefore, the brightness of light emitting device (LED) can be improved remarkably by using Al for a back side electrode.

(a4) Summing-up.

It was found as a result of the above-mentioned measurements in terms of the reflectivity at the Ti, In or Al / ZnSe interface that the reflectivity is as low as about 20% - 30 % when a Ti electrode and/or In electrode is used, while the reflectivity is as high as about 75 % when an Al electrode is used. Thus, it was proved that when a Ti layer or In layer is used as a back side electrode of a white LED, the absorption loss of light in the back side electrode is high and that the absorption loss is substantially decreased when an Al layer is used as the back side electrode. The brightness can be enhanced without wasting light by using an Al layer for an electrode on the mounting surface opposite the output surface, since light is reflected at the mounting surface and is directed toward the output surface.

(Embodiment 2)

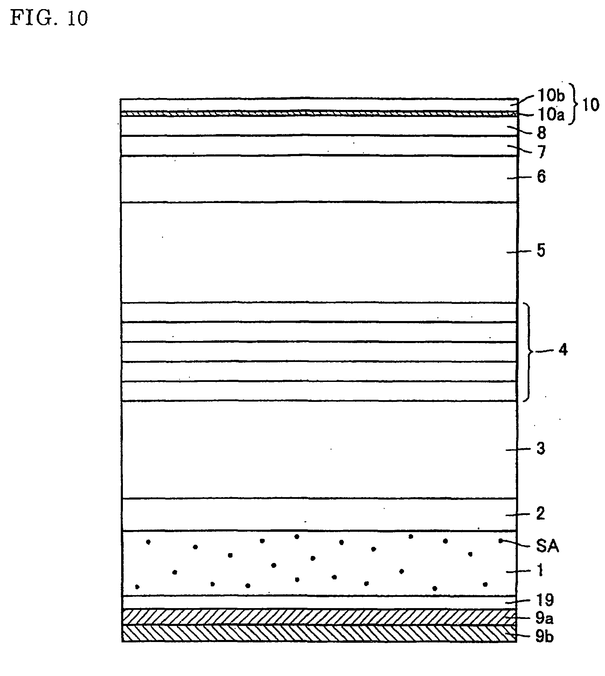

Figure 10 is a sectional view of a ZnSe light emitting device according to Embodiment 2 of the present invention. As shown in Fig. 10, there are provided on or above a n-type ZnSe single-crystal substrate 1 in the enumerated order, an n-type ZnSe buffer layer 2 having a thickness of 1 $\mu$m, an n-type ZnMgSSe cladding layer 3 having a thickness of 0.5 $\mu$m, an active layer 4 having a ZnSe / ZnCdSe multiple quantum well structure, a p-type ZnMgSSe cladding layer 5 having a thickness of 0.5 $\mu$m, a p-type ZnSe layer 6 having a thickness of 0.2 $\mu$m, and a p-type contact layer 7 consisting of a laminated superlattice structure of ZnTe and ZnSe. On the top of them, a p-type ZnTe layer 8 having a thickness of 40 nm is formed. Moreover, a p-type electrode 10 consisting of an Au film 10a and a grid Ti/Au film 10b is formed on such an epitaxial structure.

The surface of the p-type ZnSe epitaxial film is covered with a thin gold (Au) film so that an electric current flows, prevailing in the whole pn-junction in the active layer, since the intensity of light emitted in the pn-junction is higher at a position where electric current density from an electrode is higher. The thinner the thickness of the gold film, the better. If it is too thin, however, light cannot be emitted uniformly.

Self-Activated (SA) radiative recombination centers having the center of light wavelength within the range of 550nm - 650 nm is formed in an n-type ZnSe substrate 1 by doping at least one kind of n-type impurities selected from the group consisting of iodine, aluminum, chlorine, bromine, gallium, indium, and the like, followed by the irradiation of light with the wavelength of 510nm or less. It is to be noted that, each layer formed on the ZnSe substrate is all an epitaxial layer, though it is not always mentioned as such hereinafter.

The most characteristic point of the light emitting device shown in Fig. 10 is that the Al layer 9a is provided at the rear surface of the n-type ZnSe substrate. The n$^+$ type ZnSe layer 19 containing an n-type impurity at a higher concentration than the ZnSe substrate is provided between the Al layer 9a and the n-type ZnSe substrate 1. It is desirable that the n$^+$ type ZnSe layer 19 be an epitaxial film. Providing such an n-type ZnSe layer 19 of high concentration therebetween enables the Al layer 9a to achieve an ohmic contact with the n-type ZnSe substrate 1. The Al layer 9a is covered with an Au film 9b so as to protect the unstable-ness of the Al layer.

As mentioned above, most of the light would have otherwise been absorbed in the Ti layer or In layer and lost in the past can be reflected to the output surface side by the Al layer provided at the back side electrode of the n-type ZnSe substrate. Consequently, the output of the ZnSe light emitting device can be improved and the brightness can be enhanced. Also, most of the long wavelength range light of SA light generation directed toward the back side electrode, which has been considered as absorption loss in the past, can be reflected toward the output surface side and used effectively. Moreover, the SA radiative recombination centers are excited once again when the short wavelength range light from the active layer that has been reflected at the Al layer passes therethrough toward the output surface side, and thereby light of a long wavelength range is emitted. The short wavelength range light that has contributed for the excitation is absorbed and lost. Accordingly, the intensity of the long wavelength range light becomes relatively high compared with the intensity of the short wavelength range light, whereby white light can be brought closer to the perfect white light. That is, the chromaticity of the white light can be adjusted in addition to the improvement of brightness.

(Example)

The effect of an Al layer was verified by preparing a ZnSe light emitting device according to Embodiment 2. The example of the present invention is the ZnSe light emitting device shown in Fig. 10, and an Al layer 9a is provided at the rear surface of the ZnSe substrate 1. Also, the n$^+$ type ZnSe layer 19 is provided between the Al layer 9a and ZnSe substrate 1, and an Au layer 9b is stacked on the Al layer 9a. Also, the ZnSe light emitting device using a Ti layer instead of the Al layer was prepared as a comparative example. The brightness and chromaticity were measured with respect to the example of the present invention and the comparative example, respectively. The chromaticity was measured from a position directly above the sample. The results are shown in Table I.

Table I

| Case Properties | Example Al / Au electrode | Comparative Example Ti / Au electrode |
|---|---|---|
| Vf (V) | 2.67 | 2.65 |
| Output (mW) | 2.72 | 1.83 |
| Chromaticity (X, Y) | (0.208, 0.261) | (0.184, 0.261) |

As shown in Table I, the electrode consisting of Ti/Au exhibited an output of 1.83 mW as in the past. On the other hand, the example of the present invention exhibited an output of 2.72 mW, which is about 1.5 times that of the comparative example. In the case where the Ti layer was used, the chromaticity (X, Y) was (0.184, 0.261) and was a cold color, white. However, the chromaticity (X, Y) became (0.208, 0.261) when the Al layer was adopted, which resulted in the increase of a warm color component. Thus, employing an Al electrode enables the improvement of output and the control of chromaticity, and hence a high-output white LED can be obtained. Also, the variation in output and tone of color can be suppressed by the rear surface reflecting the light generated in the active layer.

(Embodiment 3)

Figure 11 is a sectional view illustrating a ZnSe light emitting device according to Embodiment 3 of the present invention. This embodiment is
characterized in ZnSe-substrate-up (p-type layer down) mounting. Because of p-type layer down mounting, it is unnecessary to form a Ti/Au film all over the surface of the n-type ZnSe substrate which constitutes an output surface, though the p-type electrode must cover the whole surface such that an electric current having a density of a given value or higher is supplied to the whole active layer. Therefore, a grid electrode 12 is provided on the output surface 16. Because of such structure, it is unnecessary to use a p-type electrode Ti/Au film covering the whole output surface, and brightness can be increased further accordingly as a result of p-type-layer down mounting in addition to the effect of reflection by the Al layer.

As shown in Fig. 11, a high-concentration ZnSe epitaxial layer 15, which contains an n-type impurity at a concentration higher than the n-type ZnSe substrate 1, is provided on the surface of the substrate 1. A grid electrode 12 consisting of Ti/Au is provided on the high-concentration ZnSe epitaxial layer 15. The high-concentration ZnSe epitaxial layer 15 is provided so that the Ti/Au grid electrode 12 can easily become an ohmic electrode. This high-concentration ZnSe epitaxial layer 15 also forms an output surface 16 in the light emitting equipment.

On the above-mentioned ZnSe substrate, there are provided in the enumerated order toward the bottom, an n-type ZnSe buffer layer 2, an n-type ZnMgSSe cladding layer 3, a ZnSe/ZnCdSe multiple quantum well structure active layer 4, a p-type ZnMgSSe cladding layer 5, a p-type ZnTe/ZnSe superlattice contact layer 7, and an Al layer 9a and an Au layer 9b. On the p-type ZnTe/ZnSe superlattice contact layer 7, an ohmic electrode Au is provided in a grid form in the peripheral area, and moreover a honeycomb Au electrode is formed so as to expand an electric current all over the chip surface. This electrode is provided with an Al layer all over so as to reflect light that is originated from the active layer and emitted from the honeycomb opening. The electrode on the bottom side may be such that the metal making an ohmic contact is either (s1) discretely arranged covering an area of a given percentage in the surface or (s2) continuously arranged with an opening covering an area at a given ratio in the surface, the remaining area being covered with the Al layer. The arrangement in the combination of the grid electrode of the Au film and the honeycomb-shape according to the above-described embodiment corresponds to the case of above (s2) in which an open area is provided continuously at a given ratio. A metal of ohmic contact may be discretely arranged in the whole surface of the bottom electrode, though a grid electrode was formed with a metal (Au) making ohmic contact arranged in the peripheral area in the above-mentioned bottom electrode. That is, the arrangement of (s1) is also possible.

According to the structure of the Fig. 11, unlike the epi-up structure, there is no Au film that covers the whole area of the output surface. Therefore, light to be emitted is not absorbed in the Au electrode film, which results in high intensity to that extent. Moreover, as described in detail in Embodiment 2, the brightness of light from the active layer can be improved further by the reflection of the Al layer provided partially at the p-side electrode. The intensity of warmer color light in the white light of cold color can be enhanced because of the reason described in Embodiment 2, which results in emitted light being closer to the complete white light.

The embodiments of the present invention described above are exemplary, and the scope of the present invention is not limited to them. The scope of the present invention is defined by the scope described in the claims, and any equivalents thereof, including all variations, are intended to be in the scope of the invention.

Industrial applicability

In a semiconductor light emitting device of the present invention, the component of SA light can be increased and chromaticity can be easily adjusted with high intensity by employing an Al layer for an electrode at the surface opposite the output surface.

**Claims**

1. A semiconductor light emitting device for emitting light outside from an output surface thereof, said device comprising a first conductivity-type semiconductor substrate including self activated radiative recombination centers, an active layer provided above said first conductivity-type semiconductor substrate, and an Al layer that is provided on the surface opposite said output surface and that reflects light toward said output surface side.

2. A semiconductor light emitting device according to claim 1, wherein said output surface is located on the side of the second conductivity-type semiconductor layer formed on said active layer, and said Al layer constitutes an electrode that is electrically connected to said first conductivity-type semiconductor substrate.

3. A semiconductor light emitting device according to claim 2, wherein a high-concentration first conductivity-type semiconductor layer is provided on the surface of said first conductivity-type semiconductor substrate, said high-concentration first conductivity-type semiconductor layer containing a first conductivity-type impurity at higher concentration than that of said first conductivity-type semiconductor substrate, and said Al layer is in contact with said high-concentration first conductivity-type semiconductor layer.

4. A semiconductor light emitting device according to claim 1, wherein said output surface is located on the side of said first conductivity-type semiconductor substrate, and said Al layer is located on the side of said second conductivity-type semiconductor layer formed on said active layer.

5. A semiconductor light emitting device according to any one of claims 1 to 4, wherein an Au layer and/or a multi-layer of Ti and Au layers are provided on said Al layer.

6. A semiconductor light emitting device according to any one of claims 1 to 5, wherein said first conductivity-type semiconductor substrate is an n-type ZnSe substrate including self activated radiative recombination centers, and said active layer formed above said n-type ZnSe substrate includes a pn-junction.

FIG. 1 (a)

Reflection R1

Reflection R0

Measurement of reflection r1

Incident light

Absorption a

FIG. 1 (b)

Reflection R0

Reflection R0

Measurement of reflection r0

Measurement of transmission T0

Incident light

Transmission T0

Absorption a

FIG. 2

FIG. 3

## FIG. 4

Legend:
- PVT-as-grown absorption coefficient
- PVT-AI absorption coefficient
- CVT absorption coefficient

Y-axis: Absorption coefficient $(cm^{-1})$ a
X-axis: Wavelength (nm)

## FIG. 5

Legend:
- PVT-asgrown reflectivity
- PVT-AI reflectivity
- CVT reflectivity

Y-axis: Reflectivity R0
X-axis: Wavelength (nm)

FIG. 6

FIG. 7

FIG. 8

FIG. 9

FIG. 10

## FIG. 11

## FIG. 12

## INTERNATIONAL SEARCH REPORT

| | International application No. |
| --- | --- |
| | PCT/JP03/06234 |

**A. CLASSIFICATION OF SUBJECT MATTER**
Int.Cl$^7$ H01L33/00

According to International Patent Classification (IPC) or to both national classification and IPC

**B. FIELDS SEARCHED**

Minimum documentation searched (classification system followed by classification symbols)
Int.Cl$^7$ H01L33/00

Documentation searched other than minimum documentation to the extent that such documents are included in the fields searched

| | | | |
| --- | --- | --- | --- |
| Jitsuyo Shinan Koho | 1922–1996 | Toroku Jitsuyo Shinan Koho | 1994–2003 |
| Kokai Jitsuyo Shinan Koho | 1971–2003 | Jitsuyo Shinan Toroku Koho | 1996–2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | EP 1150360 A2 (SUMITOMO ELECTRIC INDUSTRIES, LTD.), 31 October, 2001 (31.10.01), Full text; all drawings & US 2001/55887 A1 & JP 2002-16051 A | 1-6 |
| Y | EP 971421 A2 (SUMITOMO ELECTRIC INDUSTRIES, LTD.), 12 January, 2000 (12.01.00), Full text; all drawings & US 6337536 B1 & JP 2000-150690 A | 1-6 |
| Y | JP 2000-164931 A (SUMITOMO ELECTRIC INDUSTRIES, LTD.), 16 June, 2000 (16.06.00), Full text; all drawings (Family: none) | 1-6 |

☒ Further documents are listed in the continuation of Box C.  ☐ See patent family annex.

| | |
| --- | --- |
| *  Special categories of cited documents:<br>"A"  document defining the general state of the art which is not considered to be of particular relevance<br>"E"  earlier document but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| 10 June, 2003 (10.06.03) | 24 June, 2003 (24.06.03) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

16

**EP 1 519 423 A1**

### INTERNATIONAL SEARCH REPORT

| International application No. |
| --- |
| PCT/JP03/06234 |

| C (Continuation). DOCUMENTS CONSIDERED TO BE RELEVANT | | |
| --- | --- | --- |
| Category* | Citation of document, with indication, where appropriate, of the relevant passages | Relevant to claim No. |
| Y | JP 10-56203 A (Nippon Sanso Corp.),<br>24 February, 1998 (24.02.98),<br>Full text; all drawings<br>(Family: none) | 1-5 |
| A | JP 2000-261034 A (SUMITOMO ELECTRIC INDUSTRIES,<br>LTD.),<br>22 September, 2000 (22.09.00),<br>Full text; all drawings<br>(Family: none) | 1-5 |
| A | JP 4-186679 A (Daido Steel Co., Ltd.),<br>03 July, 1992 (03.07.92),<br>Full text; all drawings<br>(Family: none) | 1-5 |
| Y | JP 6-45651 A (Sanyo Electric Co., Ltd.),<br>18 February, 1994 (18.02.94),<br>Par. No. [0013]<br>(Family: none) | 1-6 |
| Y | JP 2001-168392 A (Stanley Electric Co., Ltd.),<br>22 June, 2001 (22.06.01),<br>Par. No. [0081]<br>(Family: none) | 1-6 |
| A | JP 4-63479 A (Sharp Corp.),<br>28 February, 1992 (28.02.92),<br>Page 8, upper right column, lines 8 to 10;<br>Page 10, lower left column, line 17 to upper<br>right column, line 6<br>(Family: none) | 1-6 |

Form PCT/ISA/210 (continuation of second sheet) (July 1998)